# EUROPEAN PATENT APPLICATION

(11) **EP 4 668 002 A1**
(43) Date of publication of application: **24.12.2025**
(21) Application number: 24756843.9
(22) Date of filing: 09.02.2024
(51) Int. Cl.: G02C 7/00, B81C 99/00, G02B 5/32, G02B 27/02, G02C 7/02

(54) **METHOD FOR MANUFACTURING SPECTACLE LENS, SEMI-FINISHED LENS, SPECTACLE LENS, AND SPECTACLES**

(30) Priority: 13.02.2023 JP 2023020132
(71) Applicant: Hoya Lens Thailand Ltd., Pathumthani 12130 (TH)
(72) Inventor: MUKAIYAMA Hiroyuki, Tokyo 160-8347 (JP)
(74) Representative: Betten & Resch
(86) International application number: PCT/JP2024/004688
(87) International publication number: WO 2024/171998

(57) **Abstract**

Provided are a method for producing a spectacle lens 1 that satisfies a wearer's prescription, the spectacle lens 1 irradiating a hologram layer 21 within the spectacle lens 1 with laser light reflected by a MEMS (micro-electromechanical systems) mirror to allow a wearer of the spectacle lens 1 to visually recognize a virtual image, as well as related technology thereof. The method includes: a step of producing the spectacle lens 1 by processing, in a semi-finished lens in which one surface H1 of a plate-like hologram portion 2 including the hologram layer 21 is adjacent to one surface B2 of a first lens blank with two surfaces, the other surface B1 of the first lens blank in accordance with the prescription to form an object-side surface S1 of the spectacle lens 1, thereby obtaining the spectacle lens 1 that satisfies the prescription.

## Description

### [Technical Field]

The present invention relates to a method for producing a spectacle lens, a semi-finished lens, a spectacle lens, and spectacles. Particularly, the present invention relates to a method for producing a spectacle lens that satisfies a wearer's prescription, the spectacle lens irradiating a hologram layer within the spectacle lens with laser light reflected by a MEMS (micro-electromechanical systems) mirror to allow a wearer of the spectacle lens to visually recognize a virtual image, a semi-finished lens, a spectacle lens, and spectacles.

### [Background Art]

PTL 1 describes a spectacle-type image display device. The device is a display device that displays an image on a lens surface of the spectacles to allow a user wearing the spectacles (referred to as a "wearer" in the present specification) to view the image.

The device includes an image output unit. The image output unit has a light output unit. It is described that the light output unit is composed of, for example, a MEMS (Micro Electro Mechanical Systems) scan display, which includes a light source and a display, and reflects the irradiation light emitted from the light source onto the display, thereby outputting it as image light containing image information.

Further, in the device, the lens has a lens substrate and a reflective hologram, which serves as an optical element provided on the surface of the lens substrate. In this case, one of the two surfaces of the reflective hologram forms the object-side surface of the spectacle lens, which is the surface on the side away from the wearer (the upper surface in Fig. 3 of PTL 1). That is, it is described that the object-side surface of the spectacle lens is one surface of the reflective hologram.

### [Citation List]

### [Patent Literature]

[PTL 1] Japanese Patent Application Laid-open No. 2022-101004

### [Summary of Invention]

### [Solution to Problem]

It is possible for a person who prepares the lens substrate described in PTL 1 to produce, from a lens blank, a lens that satisfies the prescription (spherical power S, cylindrical power C, astigmatism axis Ax, addition power ADD in the case of progressive power lens, and prism power Δ where necessary) after receiving an order for the spectacle lens. On the other hand, such a post-order production method requires much time to produce the lens. In particular, in recent years, the demand for spectacle lenses that provide virtual images has been increasing, and the time until the spectacle lenses, and by extension, the spectacles are delivered to the purchasers becomes extremely long (problem (1)).

As a method for solving the above problem (1), the preparation of a semi-finished lens in which a reflective hologram and a lens substrate as used in PTL 1 are joined in advance can be considered.

A general semi-finished lens is used to obtain a spectacle lens that ultimately satisfies the prescription by processing (such as cutting and polishing) the other surface of a lens blank, while processing one surface of the lens blank with two surfaces into a specified shape in advance.

The term "surface" that will be described in the present specification refers to two surfaces of the spectacle lens that face each other in the direction of the line of sight (the optical-axis direction, the thickness direction of the spectacle lens, or the z direction described later) when the wearer wears the spectacle lens, and does not refer to lateral surfaces (edge surfaces) unless otherwise specifically noted. This definition applies to the semi-finished lens, the lens blank, and the hologram portion described below, as well as to the spectacle lenses and spectacles ultimately obtained.

In a general semi-finished lens, the surface that is to be disposed on the object side when formed into a spectacle lens is provided in advance with a specified shape, while the surface that is to be disposed on the eye side when formed into the spectacle lens is processed. This is because the eye-side surface of the spectacle lens, which is generally formed into a meniscus shape, has a concave shape, which is more advantageous than a convex shape for performing processing such as cutting and polishing.

As a method for solving the above problem (1), the present inventor has found that, when preparing a semi-finished lens in which a reflective hologram and a lens substrate as used in PTL 1 are joined in advance, it is necessary to consider the following points when the reflective hologram is disposed on the object side and the lens substrate is disposed on the eye side as described in Fig. 3 of PTL 1.

The MEMS scan display of PTL 1 has the function of reflecting laser light at the MEMS mirror, further reflecting the laser light at the hologram layer on the spectacle lens, and causing the laser light to be incident on the pupil of the wearer, thereby outputting the laser light as image light containing image information. This mechanism is also simply referred to as "MEMS."

The lens substrate is present on the side closer to the wearer than the reflective hologram in PTL 1. As a result, the refractive power of the above laser light changes at a plurality of spots, such as the interface between the reflective hologram and the lens substrate, and the interface between the lens substrate and the outside world. On the other hand, if the shapes at the plurality of spots do not change depending on the wearer, a change in the form of the reflective hologram (for example, a change in the shapes of the two surfaces of the reflective hologram, the adjustment of the MEMS mirror, and/or the adjustment of the laser light) can eliminate or significantly reduce the impact of the change in the refractive power. The state in which the shapes at the plurality of spots do not change depending on the wearer is also simply referred to as "surface fixation (Fix)."

However, as described above, in a general semi-finished lens, the surface that is to be disposed on the object side when formed into a spectacle lens is provided in advance with a specified shape, while the surface that is to be disposed on the eye side when formed into the spectacle lens is processed. That is, at one of the plurality of spots described above, namely, at the eye-side surface of the semi-finished lens, a change in the refractive power varies depending on the prescription of the wearer. That is, in the conventional general concept, the eye-side surface of the semi-finished lens is not fixed. If no action is taken, the wearer may not be able to visually recognize a clear virtual image (problem (2)).

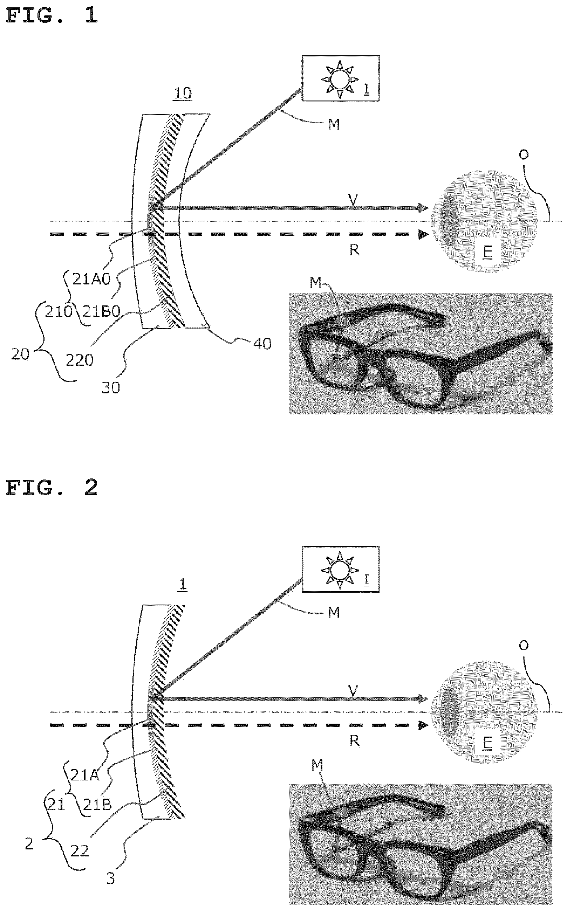

Fig. 1 shows the outline of the problem (2).

Fig. 1 is a schematic cross-sectional plan view showing that a spectacle lens functions as a part of a virtual image display system when the eye-side surface of a semi-finished lens is processed in accordance with a wearer's prescription, wherein the lower left view shows the state of laser light reflection when the spectacle lens is fitted into spectacles.

Note that for the convenience of explanation, Fig. 1 illustrates a structure in which a hologram portion is sandwiched between respective lenses from the object side and the eye side, unlike the contents described in PTL 1. Furthermore, Fig. 1 merely illustrates a reference example and does not illustrate a known example. Note that in the case of the reference example, 0 (zero) is added to the reference signs of the respective components in one embodiment of the present invention.

For the convenience of explanation, in the present specification, reference signs are given to two surfaces of each portion forming a spectacle lens or a semi-finished lens, while reference signs for the other components are omitted. The reference signs will be listed at the end of the present specification.

The above action includes changing the form of the reflective hologram (the hologram portion as described in the present specification) while taking the change in the refractive power at the plurality of spots into consideration, like the case in which the above surface F20 is fixed. On the other hand, changing the form of the reflective hologram implies not only that the reflective hologram must be reshaped from the beginning, but also that the reshaped reflective hologram must be combined with the lens substrate again to reconfirm whether the wearer can visually recognize a clear virtual image. Then, the shape of the eye-side surface F20 of the semi-finished lens varies depending on the wearer. That is, the change in the refractive power at the surface F20 varies depending on the prescription of the wearer. As a result, the above confirmation must be performed for each wearer. Accordingly, the time until the spectacle lens, and by extension, the spectacles are delivered to the purchaser becomes extremely long.

If a semi-finished lens is prepared in which the reflective hologram is disposed on the object side and the lens substrate is disposed on the eye side as described in PTL 1, there is an advantage that the reflective hologram is not damaged even when the lens substrate on the eye side is processed. On the other hand, when the semi-finished lens is employed, the above-described change in the refractive power at the plurality of spots must be taken into consideration as shown in the above problem (2). That is, when using the semi-finished lens, it is necessary to achieve both the avoidance of damage to the reflective hologram during processing on the semi-finished lens and the solution to the above problem (2) (problem (3)).

One embodiment according to a method for producing a spectacle lens in the present invention aims to solve the above problems (1) to (3).

One embodiment according to a semi-finished lens in the present invention aims to solve the above problem (1). Suitably, the one embodiment aims to solve the above problems (1) to (3).

One embodiment according to a spectacle lens or spectacles in the present invention aims to solve the above problem (2).

### [Solution to Problem]

With respect to one embodiment according to a method for producing a spectacle lens in the present invention, the present inventor has made the following findings. That is, it has been found that, in contrast to the configuration described in PTL 1, a lens blank is disposed on the object side, while a hologram portion is disposed on the eye side. Further, it has been found that the object-side surface of the lens blank is processed to achieve the prescription.

More specifically, in one embodiment according to the method for producing the spectacle lens in the present invention, the shapes of the two surfaces of the hologram portion are taken as a premise. The eye-side surface of the lens blank is processed in advance so as to be adjacent to (for example, joined at the surface with) the shape of one of the surfaces of the hologram portion. It has been found that the object-side surface of the lens blank can be processed into a free shape, and is processed to satisfy the prescription of the ordered spectacle lens. That is, it has been found that the eye-side surface of the semi-finished lens is fixed. The findings described in the previous and present paragraphs are referred to as finding (1).

Fig. 2 shows the outline of the above finding (1).

Fig. 2 is a schematic cross-sectional plan view showing that a spectacle lens functions as a part of a virtual image display system when the eye-side surface of a semi-finished lens is processed in accordance with a wearer's prescription, wherein the lower left view shows the state of laser light reflection when the spectacle lens is fitted into spectacles.

Note that Fig. 2 is an example corresponding to the first embodiment described below. Fig. 2 illustrates a case in which the portion of the lens center (optical center, geometric center, and/or centering center) in the hologram layer is exposed.

On the basis of the foregoing finding (1), the following aspects according to the method for producing the spectacle lens in the present invention have been contemplated.

A first aspect of the present invention provides
a method for producing a spectacle lens that satisfies a wearer's prescription, the spectacle lens irradiating a hologram layer within the spectacle lens with laser light reflected by a MEMS (micro-electromechanical systems) mirror to allow a wearer of the spectacle lens to visually recognize a virtual image, the method including:
a step of producing the spectacle lens by processing, in a semi-finished lens in which one surface H1 of a plate-like hologram portion including the hologram layer is adjacent to one surface B2 of a first lens blank with two surfaces, the other surface B1 of the first lens blank in accordance with the prescription to form an object-side surface S1 of the spectacle lens, thereby obtaining the spectacle lens that satisfies the prescription.

A second aspect of the present invention provides
the method for producing the spectacle lens according to the first aspect, wherein an eye-side surface S2 of the spectacle lens is the other surface H2 of the hologram portion.

A third aspect of the present invention provides
the method for producing the spectacle lens according to the first aspect, wherein the hologram portion has a shape that follows the hologram layer.

A fourth aspect of the present invention provides
the method for producing the spectacle lens according to the first aspect, wherein the hologram portion is composed of the hologram layer joined to a layered base portion.

A fifth aspect of the present invention provides
the method for producing the spectacle lens according to the first aspect, wherein a distance d2 in a lens thickness direction from an eye-side surface S2 of the spectacle lens to the hologram layer is set to be smaller than a distance d1 in the lens thickness direction from the object-side surface S1 of the spectacle lens to the hologram layer.

A sixth aspect of the present invention provides
the method for producing the spectacle lens according to the fifth aspect, wherein a value of the d2/the d1 is 0.2 or less.

A seventh aspect of the present invention provides
the method for producing the spectacle lens according to the first aspect, wherein the hologram portion has a cylindrical shape that curves in a horizontal direction,
a surface H2 of the hologram portion is adjacent to one surface B'1 of a second lens blank with two surfaces,
the other surface B'2 of the second lens blank has a concave and spherical shape, and
the surface B1 of the first lens blank is formed into a convex or flat shape in the step of producing.

With respect to one embodiment according to a semi-finished lens in the present invention, it has been found that, in order to solve the above problem (1), a semi-finished lens is prepared which includes a first lens blank and a plate-like hologram portion including a hologram layer, wherein one surface B2 of the first lens blank with two surfaces is adjacent to one surface H1 of the hologram portion (finding (2)). That is, it has been found that the semi-finished lens including the hologram portion in advance is prepared. In addition, the above finding (1) has also been obtained.

On the basis of the findings (1) and (2) described above, the following aspects according to the semi-finished lens in the present invention have been contemplated.

An eighth aspect of the present invention provides
a semi-finished lens for producing a spectacle lens that satisfies a wearer's prescription, the spectacle lens irradiating a hologram layer within the spectacle lens with laser light reflected by a MEMS (micro-electromechanical systems) mirror to allow a wearer of the spectacle lens to visually recognize a virtual image, the semi-finished lens including:
a first lens blank; and
a plate-like hologram portion that includes the hologram layer, wherein
one surface B2 of the first lens blank with two surfaces is adjacent to one surface H1 of the hologram portion,
one surface F1 of the semi-finished lens with two surfaces is the other surface B1 of the first lens blank, and
the other surface F2 of the semi-finished lens is the other surface H2 of the hologram portion.

A ninth aspect of the present invention provides
a semi-finished lens for producing a spectacle lens that satisfies a wearer's prescription, the spectacle lens irradiating a hologram layer within the spectacle lens with laser light reflected by a MEMS (micro-electromechanical systems) mirror to allow a wearer of the spectacle lens to visually recognize a virtual image, the semi-finished lens including:
a first lens blank; and
a second lens blank; and
a plate-like hologram portion that includes the hologram layer, wherein
the hologram portion has a cylindrical shape that curves in a horizontal direction,
   one surface B2 of the first lens blank with two surfaces is adjacent to one surface H1 of the hologram portion,
a surface H2 of the hologram portion is adjacent to one surface B'1 of the second lens blank with two surfaces,
the other surface B'2 of the second lens blank has a concave and spherical shape, and
   one surface F1 of the semi-finished lens with two surfaces is the other surface B1 of the first lens blank, and
the other surface F2 of the semi-finished lens is the surface B'2 of the second lens blank.

A tenth aspect of the present invention provides
the semi-finished lens according to the eighth or ninth aspect, wherein the hologram portion has a shape that follows the hologram layer.

An eleventh aspect of the present invention provides
the semi-finished lens according to the eighth or ninth aspect, wherein the hologram portion is composed of the hologram layer joined to a layered base portion.

A twelfth aspect of the present invention provides
the semi-finished lens according to the eighth or ninth aspect, wherein a distance t2 in a lens thickness direction from the surface F2 of the semi-finished lens to the hologram layer is set to be smaller than a distance t1 in the lens thickness direction from the surface F1 of the semi-finished lens to the hologram layer.

A thirteenth aspect of the present invention provides
the semi-finished lens according to the twelfth aspect, wherein a value of the t2/the t1 is 0.2 or less.

With respect to one embodiment according to a spectacle lens or spectacles in the present invention, the present inventor has found the following contents. That is, in a case where a first lens, in which a first lens blank is processed in accordance with the prescription (specifically, so that the first lens blank alone satisfies the prescription), is disposed on the object side, and a plate-like hologram portion including a hologram layer is disposed on the eye side, while no lens is disposed on the eye side as viewed from the hologram portion, (which is also referred to as "lens-free" in the present specification), or in a case where, even if a second lens is disposed, "the hologram portion has a cylindrical shape that curves in the horizontal direction, and the eye-side surface of the second lens has a simple concave and spherical shape," (which will be described in detail in the embodiments and is also referred to as a "simple fixed-lens" in the present specification), the present inventor has found that a clear virtual image can be obtained because a virtual image is of a type that is not focused on the retina, like a MEMS.

In other words, when a wearer is caused to visually recognize a virtual image of the type that is formed on the retina, the eye side of the lens blank is not processed in accordance with the wearer if the lens-free or simple fixed-lens is employed. As a result, it is not possible for the wearer to visually recognize the virtual image while satisfying the prescription. On the other hand, in the spectacle lens or the spectacles in the present invention, the wearer is caused to visually recognize a virtual image of the type that is not formed on the retina, like a MEMS. Therefore, the content described in the previous text need not be taken into consideration. This is because the following aspects according to the spectacle lens or the spectacles in the present invention are effective for a virtual image of the type that is not formed on the retina, like the MEMS. The findings described in the preceding and present paragraphs are referred to as finding (3).

On the basis of the foregoing finding (3), the following aspects of the spectacle lens or the spectacles in the present invention have been contemplated.

A fourteenth aspect of the present invention provides
a spectacle lens that satisfies a wearer's prescription, the spectacle lens irradiating a hologram layer within the spectacle lens with laser light reflected by a MEMS (micro-electromechanical systems) mirror to allow a wearer of the spectacle lens to visually recognize a virtual image, the spectacle lens including:
a first lens; and
a plate-like hologram portion that includes the hologram layer, wherein
one surface L2 of the first lens with two surfaces is adjacent to one surface H1 of the hologram portion,
an object-side surface S1 of the spectacle lens is the other surface L1 of the first lens, and
an eye-side surface S2 of the spectacle lens is the other surface H2 of the hologram portion.

A fifteenth aspect of the present invention provides
a spectacle lens that satisfies a wearer's prescription, the spectacle lens irradiating a hologram layer within the spectacle lens with laser light reflected by a MEMS (micro-electromechanical systems) mirror to allow a wearer of the spectacle lens to visually recognize a virtual image, the spectacle lens including:
a first lens; and
a second lens; and
a plate-like hologram portion that includes the hologram layer, wherein
the hologram portion has a cylindrical shape that curves in a horizontal direction,
one surface L2 of the first lens with two surfaces is adjacent to one surface H1 of the hologram portion,
a surface H2 of the hologram portion is adjacent to one main surface L'1 of the second lens with two surfaces,
the other surface L'2 of the second lens has a concave and spherical shape,
a surface L1 of the first lens has a convex or flat shape,
an object-side surface S1 of the spectacle lens is the surface L1 of the first lens, and
an eye-side surface S2 of the spectacle lens is the surface L'2 of the second lens.

A sixteenth aspect of the present invention provides
the spectacle lens according to the fourteenth or fifteenth aspect, wherein the hologram portion has a shape that follows the hologram layer.

A seventeenth aspect of the present invention provides
the spectacle lens according to the fourteenth or fifteenth aspect, wherein the hologram portion is composed of the hologram layer joined to a layered base portion.

An eighteenth aspect of the present invention provides
the spectacle lens according to the fourteenth or fifteenth aspect, wherein a distance d2 in a lens thickness direction from the eye-side surface S2 of the spectacle lens to the hologram layer is smaller than a distance d1 in the lens thickness direction from the object-side surface S1 of the spectacle lens to the hologram layer.

A nineteenth aspect of the present invention provides
the spectacle lens according to the eighteenth aspect, wherein a value of the d2/the d1 is 0.2 or less.

A twentieth aspect of the present invention provides
spectacles including: the spectacle lens according to the fourteenth or fifteenth aspect; and
a spectacle frame.

Other suitable aspects are as follows. The following aspects can be combined with each of the aspects described above.

The thickness of the plate-like hologram portion is not limited. For example, the upper limit of the thickness of the hologram portion includes 2.0 mm, 1.5 mm, and 1.0 mm. The lower limit of the thickness of the hologram portion includes 0.005 mm, 0.01 mm, 0.05 mm, and 0.10 mm.

The thickness of the hologram layer is not limited. For example, the upper limit of the thickness of the hologram layer includes 20 µm, 15 µm, and 10 µm. The lower limit of the thickness of the hologram layer includes 0.1 µm, 0.5 µm, and 1 µm.

The thickness of the base portion is not limited. For example, the upper limit of the thickness of the base portion includes 2.0 mm, 1.5 mm, and 1.0 mm. The lower limit of the thickness of the base portion includes 0.01 mm, 0.05 mm, and 0.10 mm.

The term "adjacent" as used in the present specification includes not only a physical contact state with the hologram portion (for example, joined at the surface, which will be illustrated below), but also a non-contact state of proximity (for example, a separation distance at the geometric center of the lens is at most 8 mm, 5 mm, or 3 mm). One example of such a non-contact state of proximity includes a case in which another film is interposed between the hologram portion and the first lens.

### [Advantageous Effects of Invention]

One embodiment according to the method for manufacturing the spectacle lens in the present invention can solve the above problems (1) to (3).

One embodiment according to the semi-finished lens in the present invention can solve the above problem (1). Suitably, the one embodiment can solve the above problems (1) to (3).

One embodiment according to the spectacle lens or the spectacles in the present invention can solve the above problem (2).

### [Brief Description of Drawings]

[Fig. 1]
   Fig. 1 is a schematic cross-sectional plan view showing that a spectacle lens functions as a part of a virtual image display system when the eye-side surface of a semi-finished lens is processed in accordance with a wearer's prescription, wherein the lower left view shows the state of laser light reflection when the spectacle lens is fitted into spectacles.
[Fig. 2]
   Fig. 2 is a view according to one aspect of the present invention and is a schematic cross-sectional plan view showing that a spectacle lens functions as a part of a virtual image display system when the object-side surface of a semi-finished lens is processed in accordance with a wearer's prescription, wherein the lower left view shows the state of laser light reflection when the spectacle lens is fitted into spectacles.

### [Description of Embodiments]

Hereinafter, one aspect of the present invention will be described. The term "to" refers to values that are greater than or equal to a specified numerical value and less than or equal to a specified numerical value.

In a first embodiment, the aspects of the above lens-free type will be described.

In a second embodiment, the aspects of the above simple fixed-lens type will be described.

Prior to these descriptions, the content common to the first and second embodiments will be described first.

### [Common Content]

One aspect of the present invention relates to a spectacle lens, spectacles, and a lens element pertaining to a system that allows a wearer to experience virtual reality and/or augmented reality and can be mounted on a user's head.

The system according to one aspect of the present invention has an image light emission unit that causes image light associated with a MEMS to be incident on the pupil of a wearer, and the following spectacle lens. The image light emission unit refers to one that includes a configuration necessary to emit image light and cause the image light to be incident on the pupil of the wearer, and forms at least a part of the configuration of the MEMS. When the light flux of the image light is incident on the pupil, the wearer recognizes a virtual image. The virtual image is not limited and may be a moving image or a still image.

This system may be implemented as a head-mounted display or smart glasses. Hereinafter, an example in which this system is implemented as smart glasses will be described. One aspect of the present invention also relates to a spectacle lens in the smart glasses.

The "spectacle lens" in the present specification irradiates the hologram layer within the spectacle lens with laser light reflected by the MEMS (micro-electromechanical systems) mirror to allow a wearer of the spectacle lens to visually recognize a virtual image. In addition, the spectacle lens in the present specification is in a state that satisfies the prescription of the wearer.

Note that, in one aspect of the present invention, the first and second lenses may simply be plastic or glass produced from a lens blank. That is, in one aspect of the present invention, the first and the second lenses are non-variable focal lenses.

The principle of reflecting a virtual image onto the spectacle lens using the MEMS may be appropriately employed on the basis of known technology (for example, the contents described in PTL 1). For example, with respect to the descriptions of the MEMS as described in PTL 1 (such as the light source, the specific configuration of the MEMS mirror, and the driving control unit of the system), known configurations may be employed. Therefore, their detailed descriptions will be omitted in the present specification.

Furthermore, the "hologram portion" in the present specification is not limited, provided that it is a plate-like material including a hologram layer. As an example, the hologram portion may have a shape that follows the hologram layer. Furthermore, the hologram portion may be composed of the above hologram layer joined to a layered base portion.

Fig. 2 illustrates an example in which the portion of the lens center (optical center, geometric center, and/or centering center) within the hologram layer is exposed. At the exposed portion, the reflected light from the MEMS mirror is further reflected and incident on the wearer's eye, thereby allowing the wearer to perceive a virtual image. Meanwhile, the present invention is not limited to this aspect. The entire hologram layer may be exposed. In either case, the spectacle lens according to one aspect of the present invention has a see-through function, and the hologram portion is, for example, practically sufficiently transparent when gazing at a real object.

The "plate-like shape" of the hologram portion is not limited and may be either a flat plate-like shape or a curved plate-like shape. In the curved plate, both surfaces H1 and H2 may have either a spherical or aspherical shape, or both surfaces H1 and H2 may have different shapes or similar shapes (for example, the same shape). In the second embodiment, the shape of the hologram portion is limited to a cylindrical shape that is curved in the horizontal direction (for example, a shape formed by bending a flat plate only in the horizontal direction).

The thickness of the plate-like hologram portion is not limited. For example, the upper limit of the thickness of the hologram portion includes 2.0 mm, 1.5 mm, and 1.0 mm. The lower limit of the thickness of the hologram portion includes 0.005 mm, 0.01 mm, 0.05 mm, and 0.10 mm.

The thickness of the hologram layer is not limited. For example, the upper limit of the thickness of the hologram layer includes 20 µm, 15 µm, and 10 µm. The lower limit of the thickness of the hologram layer includes 0.1 µm, 0.5 µm, and 1 µm.

The thickness of the base portion is not limited. For example, the upper limit of the thickness of the base portion includes 2.0 mm, 1.5 mm, and 1.0 mm. The lower limit of the thickness of the base portion includes 0.01 mm, 0.05 mm, and 0.10 mm.

The following illustrates an example of the hologram portion described in the above paragraphs, but the present invention is not limited to this aspect. For example, the hologram portion may be such that the hologram layer, which is a flat plate-like film, is embedded in the base portion in which the flat plate is curved only in the horizontal direction as in the second embodiment, or another member may be interposed between the base portion and the hologram layer. Furthermore, the base portion may be a light guiding member or may simply be a film that supports or reinforces the hologram portion. As this "light guiding member," a light guiding member used in a technology that projects a virtual image to the wearer via a spectacle lens may be incorporated. Therefore, its detailed description will be omitted in the present specification.

The material of the base portion may be the same as or different from that of the first lens (and by extension, the first lens blank). The material of the base portion is not limited. Similarly, the material of the base portion may be the same as or different from that of the second lens (and by extension, the second lens blank) according to the second embodiment described below. Furthermore, the material of the first lens (and by extension, the first lens blank) may be the same as or different from that of the second lens (and by extension, the second lens blank) according to the second embodiment described below. Examples of the materials for each component include triacetyl cellulose (TAC), polycarbonate (PC), and the like.

The plate-like hologram portion is originally configured as a separate body from the first lens blank. An object-side surface H1 of the hologram portion and an eye-side surface B2 of the first lens blank are adjacent to each other. Specifically, both are joined to each other at their surfaces. Joining both in this way refers also to one feature as a method for producing a semi-finished lens.

Aspects of "joining" in the present specification are not limited and include joining with an adhesive and joining under thermal fusion. Furthermore, although described in the second embodiment, the plate-like hologram portion is originally configured as a separate body from the second lens blank.

The spectacle lens according to one aspect of the present invention has a see-through function and has an object-side surface S1 and an eye-side surface S2**.** The object-side surface S1 and the eye-side surface face each other, and the portion of the surface that is present facing the object-side surface in the optical axis direction as viewed from the object-side surface S1 is the eye-side surface S2**.**

The y direction referred to in the present specification is a direction along the meridian and is the vertical direction. The upper side of the lens in a worn state is defined as the +y direction, and the lower side of the lens is defined as the -y direction. The x direction is a direction orthogonal to the meridian and is the horizontal direction. When facing the wearer, the right side of the lens is defined as the +x direction, and the left side of the lens is defined as the -x direction. The direction orthogonal to both the x and y directions, which is the lens thickness direction (optical axis direction), is defined as the z direction. The direction toward the object is defined as the +z direction, and the direction toward the eye is defined as the -z direction.

The "spectacle lens" of the present specification includes at least the first lens and the hologram portion. The first lens is adjacent to the hologram portion on the object side (+z direction). The first lens has two surfaces L1 and L2, and the object-side surface L1 of the first lens serves as the object-side surface S1 of the spectacle lens. The eye-side (-z direction) surface L2 of the first lens is adjacent to the object-side surface H1 of the hologram portion.

The first lens is obtained by processing the first lens blank of the semi-finished lens in accordance with the prescription. Like the first lens, the first lens blank also has two surfaces B1 and B2. The object-side surface B1 of the first lens blank is processed in accordance with the prescription, thereby serving as the object-side surface L1 of the first lens, and by extension, the object-side surface S1 of the spectacle lens. The eye-side surface B2 of the first lens blank remains adjacent to the object-side surface H1 of the hologram portion.

Hereinafter, the respective two surfaces of the first lens, the first lens blank that forms the basis of the first lens, and the hologram portion will be expressed in the manner described in the present paragraph. In the case of the second embodiment, the second lens, which is a simple fixed-lens, and a second lens blank that forms the basis of the second lens are added to the above.

Note that the first lens is denoted by reference sign L, the first lens blank is denoted by reference sign B, the semi-finished lens is denoted by reference sign F, and the spectacle lens is denoted by reference sign S. Further, the object side is denoted by reference sign 1, and the eye side is denoted by reference sign 2. For example, the object-side surface of the first lens is denoted by the reference sign L1. Note that each reference sign of the second lens and the second lens blank of the second embodiment is labeled with "'."

Both the first lens and the second lens of the second embodiment are non-variable focal lenses made of plastic or glass. The first lens and the second lens of the second embodiment may include a hard coat layer, an anti-reflection layer, a fouling-resistant layer, and the like.

The number of lenses forming the first lens is not limited. The number of lenses forming the second lens of the second embodiment is not limited. However, increasing the number of lenses leads to an increase in the thickness of the spectacle lens. Therefore, suitably, the first lens is formed by a single lens (in which the object-side surface L1 is a convex surface), and the second lens of the second embodiment is formed by a single lens (in which the eye-side surface L'2 is a concave surface).

The term "adjacent" as used in the present specification includes not only a physical contact state with the hologram portion (for example, joined at the surface, which will be illustrated below), but also a non-contact state of proximity (for example, a separation distance at the geometric center of the lens is at most 8 mm, 5 mm, or 3 mm). One example of such a non-contact state of proximity includes a case in which another film is interposed between the hologram portion and the first lens.

The spectacle lens according to one aspect of the present invention has a see-through function. Accordingly, when a light flux that passes through the first lens and the hologram portion is focused to form a real image, the first lens and the hologram portion realize the wearer's prescription values. The realization of the wearer's prescription values is achieved by the refractive indices and surface shapes of the respective materials of the first lens and the hologram portion.

Note that in one embodiment according to the method for producing the spectacle lens in the present invention, the shapes of the two surfaces H1 and H2 of the hologram portion (that is, the object referred to as the hologram portion) are taken as a premise.

Therefore, in the first embodiment (in which the eye side of the hologram portion is lens-free), the object-side surface B1 of the first lens blank, which is to be joined to the object side of the hologram portion, is processed to satisfy the prescription, on the assumption that the hologram portion is already present.

In the second embodiment (in which the shape of the hologram portion is specified, and the eye-side surface L'2 is the second lens, which has a concave and spherical shape), the object-side surface B1 of the first lens blank, which is to be joined to the object side of the hologram portion, is processed to satisfy the prescription, on the assumption that the hologram portion and the second lens are already firmly present.

Incidentally, the wearer's prescription values are indicated on the lens bag of the spectacle lens. This also applies to a case in which a light guiding member is included, as in the spectacle lens according to one aspect of the present invention. This is because, in the spectacle lens according to one aspect of the present invention, refractive errors are corrected when recognizing the outside world. Therefore, the prescription values need to be indicated. As a result, even the spectacle lens according to one aspect of the present invention is accompanied by a lens bag.

If there is a lens bag, identification of the spectacle lens as an object is possible on the basis of the wearer's prescription values. Further, the spectacle lens is usually paired with a lens bag. Accordingly, the technical idea of the present invention is also reflected in spectacle lenses accompanied by a lens bag, and the same applies to a set consisting of a lens bag and a spectacle lens.

Examples of the wearer's prescription values include spherical power (S power) for frontal vision (at infinity), cylindrical power (C power), astigmatism axis (Ax), and prism power (Δ). In the case of a progressive power lens, addition power (ADD) is also included in addition to the above. In the present specification, "addition power" refers to the difference (a positive value in the present specification) between spherical power for frontal vision (at infinity) and the power required to correct vision for near vision.

In the above example, the spectacle lens has the object-side surface S1 as a convex surface, and the eye-side surface S2 as a concave surface. That is, in the above example, the spectacle lens is a meniscus lens.

### [First Embodiment (Lens-Free)]

In the first embodiment, the aspects of the above lens-free type (Fig. 2) will be described.

### <Semi-finished Lens>

One specific example of the configuration of the semi-finished lens in the first embodiment is as follows. Note that the present invention is also technically significant as a method for producing the following semi-finished lens.

"A semi-finished lens for producing a spectacle lens that satisfies a wearer's prescription, the spectacle lens irradiating a hologram layer within the spectacle lens with laser light reflected by a MEMS (micro-electromechanical systems) mirror to allow a wearer of the spectacle lens to visually recognize a virtual image, the semi-finished lens including:
a first lens blank; and
a plate-like hologram portion that includes the hologram layer, wherein
one surface B2 of the first lens blank with two surfaces is adjacent to one surface H1 of the hologram portion,
one surface F1 of the semi-finished lens with two surfaces is the other surface B1 of the first lens blank, and
the other surface F2 of the semi-finished lens is the other surface H2 of the hologram portion."

In the first embodiment, the surface B2 of the first lens blank is joined to the surface H1 of the hologram portion. Further, the surface F1 of the semi-finished lens is the surface B1 of the first lens blank, and the surface F2 of the semi-finished lens is the surface H2 of the hologram portion.

By employing the first embodiment, unlike a post-order production system, the time required for producing a lens can be significantly reduced. As a result, the time until a spectacle lens, and by extension spectacles, are delivered to the purchaser of the spectacle lens can be remarkably reduced, and the above problem (1) can be solved. This point also applies to the second embodiment described below.

In addition, in the first embodiment, the shapes of the two surfaces H1 and H2 of the hologram portion are taken as a premise. The eye-side surface B2 of the first lens blank is processed in advance to be joined to the one surface H2 of the hologram portion. The object-side surface B1 of the first lens blank can be processed into a free shape and is processed to satisfy the prescription of the ordered spectacle lens. This implies that the object-side surface F1 of the semi-finished lens is freely processed so that the spectacle lens satisfies the prescription. On the other hand, the eye-side surface F2 of the semi-finished lens is fixed. As a result, the above problem (2) can be solved. The point that the eye-side surface F2 of the semi-finished lens is fixed also applies to the second embodiment described below.

Moreover, when using the semi-finished lens, it is necessary to achieve both the avoidance of damage to the reflective hologram during processing on the semi-finished lens and a solution to the above problem (2) (problem (3)). In this regard, in the first embodiment, it is sufficient to fix the eye-side surface F2 of the semi-finished lens and process the object-side surface F1. Therefore, the problem (3) can be solved. This point also applies to the second embodiment described below.

The definition that expresses a resolution to the problem (3) in terms of the configuration of the semi-finished lens is as follows. Specifically, it is defined that the hologram layer is disposed closer to the eye-side surface F2 in the semi-finished lens.

A distance t2 in the lens thickness direction from the surface F2 of the semi-finished lens to the hologram layer is preferably set to be smaller than a distance t1 in the lens thickness direction from the surface F1 of the semi-finished lens to the hologram layer. As described in the problem (2), in a general semi-finished lens, the eye-side surface is processed in accordance with the prescription. The configuration described in the present paragraph is contrary to the handling of such a general semi-finished lens, namely, the processing of the object-side surface F1 in accordance with the prescription. Accordingly, the hologram layer is disposed closer to the eye-side surface F2 in the semi-finished lens. This content is defined in the present paragraph.

The following expression quantitatively defines that the hologram layer is disposed closer to the eye-side surface F2 in the semi-finished lens.
• The value of the t2/the t1 is 0.2 or less (or 0.15 or less, or 0.13 or less).

### <Method for Producing Spectacle Lens>

One specific example of the configuration of the method for producing the spectacle lens in the first embodiment is as follows.

"A method for producing a spectacle lens that satisfies a wearer's prescription, the spectacle lens irradiating a hologram layer within the spectacle lens with laser light reflected by a MEMS (micro-electromechanical systems) mirror to allow a wearer of the spectacle lens to visually recognize a virtual image, the method including:
a step of producing the spectacle lens by processing, in a semi-finished lens in which one surface H1 of a plate-like hologram portion including the hologram layer is adjacent to one surface B2 of a first lens blank with two surfaces, the other surface B1 of the first lens blank in accordance with the prescription to form an object-side surface S1 of the spectacle lens, thereby obtaining the spectacle lens that satisfies the prescription."

In the first embodiment, the surface B1 of the first lens blank is processed in accordance with the prescription to form the object-side surface S1 of the spectacle lens. To reiterate, in one embodiment of the present invention, the plate-like hologram portion is taken as a premise. In the case of the first embodiment, the surface H2 of the hologram portion serves as the eye-side surface S2 of the spectacle lens. Accordingly, by taking the form of the hologram portion into consideration in advance and processing the surface B1 of the first lens blank in accordance with the prescription to be satisfied, it is sufficient to produce the spectacle lens that satisfies the prescription. This will be referred to as "processing in accordance with the prescription." The details of the specific operations in the step of producing the spectacle lens are omitted in this specification because known techniques may be employed.

The definition that expresses the solution to the problem (3) in terms of the step of the method for producing the spectacle lens is as follows. The following contents are the same as those described in the section <Semi-finished Lens>, and therefore their detailed descriptions will be omitted. The following definition is also applicable to the section

### <Spectacle Lens and Spectacles> described below.

- A distance d2 in the lens thickness direction from the eye-side surface S2 of the spectacle lens to the hologram layer is set to be smaller than a distance d1 in the lens thickness direction from the object-side surface S1 of the spectacle lens to the hologram layer.
- The value of the d2/the d1 is 0.2 or less.

### <Spectacle Lens and Spectacles>

One specific example of the configuration of the spectacle lens in the first embodiment is as follows.

"A spectacle lens that satisfies a wearer's prescription, the spectacle lens irradiating a hologram layer within the spectacle lens with laser light reflected by a MEMS (micro-electromechanical systems) mirror to allow a wearer of the spectacle lens to visually recognize a virtual image, the spectacle lens including:
a first lens; and
a plate-like hologram portion that includes the hologram layer, wherein
one surface L2 of the first lens with two surfaces is adjacent to one surface H1 of the hologram portion,
an object-side surface S1 of the spectacle lens is the other surface L1 of the first lens, and
an eye-side surface S2 of the spectacle lens is the other surface H2 of the hologram portion."

One specific example of the configuration of the spectacles in the first embodiment is as follows.

"Spectacles including: the spectacle lens described above; and
a spectacle frame."

In the first embodiment, the spectacle lens and the spectacles are resultants in which the eye-side surface F2 of the semi-finished lens is fixed. In the first embodiment, the refractive power at the eye-side surface S2 of the spectacle lens, which corresponds to one of a plurality of spots described in PTL 1, such as the interface between the reflective hologram and the lens substrate, and the interface between the lens substrate and the outside world, does not change depending on the prescription of the wearer. This is because, in the first embodiment, which is of a lens-free type, the eye-side surface S2 of the spectacle lens is formed by the surface H2 of the hologram portion, which is taken as a premise.

As a result, the spectacle lens and the spectacles in the first embodiment allow the wearer to visually recognize a clear virtual image, thereby solving the problem (2).

The object-side surface L1 of the first lens (that is, the object-side surface S1 of the spectacle lens) may be a spherical surface or a toric surface for astigmatism correction. The spectacle lens itself may be a single-focus lens. On the other hand, the object-side surface S1 of the spectacle lens may be a progressive surface in which the power changes progressively. Note that the positions of various hidden marks (measurement reference point F, fitting point or eye point FP, and measurement reference point N) used in progressive power lenses may be identified by referring to a Remark chart or a Centration chart issued by the lens manufacturer.

### [Second Embodiment (Simple Fixed-Lens)]

In the second embodiment, the aspects of the above simple fixed-lens will be described. For the contents not described below, those described in the first embodiment may be incorporated. The definition in the first embodiment that the hologram layer is disposed closer to the eye-side surface F2 of the semi-finished lens (or is closer to the eye-side surface S2 of the ophthalmic lens) may also be incorporated. However, in the second embodiment, this definition employs the distance from a surface B'2 of the second lens blank to the hologram layer, or the distance from a surface L'2 of the second lens to the hologram layer.

<Semi-finished Lens>

One specific example of the configuration of the semi-finished lens in the second embodiment is as follows. Note that the present invention is also technically significant as a method for producing the following semi-finished lens.

"A semi-finished lens for producing a spectacle lens that satisfies a wearer's prescription, the spectacle lens irradiating a hologram layer within the spectacle lens with laser light reflected by a MEMS (micro-electromechanical systems) mirror to allow a wearer of the spectacle lens to visually recognize a virtual image, the semi-finished lens including:
a first lens blank; and
a second lens blank; and
a plate-like hologram portion that includes the hologram layer, wherein
the hologram portion has a cylindrical shape that curves in a horizontal direction,
one surface B2 of the first lens blank with two surfaces is adjacent to one surface H1 of the hologram portion,
a surface H2 of the hologram portion is adjacent to one surface B'1 of the second lens blank with two surfaces,
the other surface B'2 of the second lens blank has a concave and spherical shape, and
one surface F1 of the semi-finished lens with two surfaces is the other surface B1 of the first lens blank, and
the other surface F2 of the semi-finished lens is the surface B'2 of the second lens blank."

In the second embodiment, the surface B2 of the first lens blank is joined to the surface H1 of the hologram portion. Further, the surface F1 of the semi-finished lens is the surface B1 of the first lens blank, and the surface F2 of the semi-finished lens is the surface B'2 of the second lens blank.

In the second embodiment, unlike in the first embodiment, the second lens blank different from the first lens blank is adjacent (for example, joined at the surface) to the eye side of the surface H2 of the hologram portion. However, in the second embodiment, the shape of the hologram portion is defined as a cylindrical shape that curves only in the horizontal direction. With that in mind, the eye-side surface B'2 of the second lens blank is defined as a simple concave and spherical shape. The reason is as follows.

It is assumed that the spectacle lens is a minus lens in order to satisfy the prescription. Further, it is assumed that the hologram portion has a cylindrical shape that curves only in the horizontal direction. If the first embodiment described above is applied to this case, the surface L1 of the first lens (the object-side surface S1 of the spectacle lens) is convex in the horizontal direction (x direction), which is the direction of curvature. On the other hand, in the vertical direction (y direction), the hologram portion is flat. In the first embodiment, only the first lens is present as a lens. That is, the negative lens must be realized only by the first lens blank. In this case, the first lens must be concave in the vertical direction. As a result, the object-side surface S1 of the spectacle lens must have a distorted shape that is convex in the horizontal direction but concave in the vertical direction.

Therefore, the second embodiment employs the semi-finished lens in which the second lens blank is disposed on the eye side of the hologram portion. If the second lens blank is present, it is not necessary to realize the negative lens only with the first lens blank. If the surface B'2 of the second lens blank has a concave and spherical shape, it is not necessary to forcibly process the first lens blank into a concave shape in the vertical direction.

Because the semi-finished lens is provided, the above problem (1) can be solved through the aspects of the second embodiment.

Regarding the above problem (2), the second embodiment assumes the case in which the hologram portion has a cylindrical shape that curves only in the horizontal direction. In addition, it also assumes that the surface B'2 of the second lens blank has a concave and spherical shape. Further, the processing of the surface B1 of the first lens blank to satisfy the prescription of the spectacle lens is the same as in the first embodiment. That is, in the second embodiment as well, the eye-side surface of the semi-finished lens is fixed. As a result, the above problem (2) can be solved through the aspects of the second embodiment.

Moreover, when using the semi-finished lens, it is necessary to achieve both the avoidance of damage to the reflective hologram during processing on the semi-finished lens and the solution to the above problem (2) (problem (3)). In this regard, in the second embodiment, it is sufficient to fix the eye-side surface F2 of the semi-finished lens and process the object-side surface F1. Therefore, the problem (3) can be solved.

The first and second embodiments are common in the technical concept that "the eye-side surface F2 of the semi-finished lens is fixed" and "by extension, the fixation is also reflected in the spectacle lens obtained from the semi-finished lens."

### <Method for Producing Spectacle Lens>

One specific example of the configuration of the method for producing the spectacle lens in the second embodiment is as follows.

"A method for producing a spectacle lens that satisfies a wearer's prescription, the spectacle lens irradiating a hologram layer within the spectacle lens with laser light reflected by a MEMS (micro-electromechanical systems) mirror to allow a wearer of the spectacle lens to visually recognize a virtual image, the method including:
a step of producing the spectacle lens by processing, in a semi-finished lens in which one surface H1 of a plate-like hologram portion including the hologram layer is adjacent to one surface B2 of a first lens blank with two surfaces, the other surface B1 of the first lens blank in accordance with the prescription to form an object-side surface S1 of the spectacle lens, thereby obtaining the spectacle lens that satisfies the prescription, wherein
the hologram portion has a cylindrical shape that curves in a horizontal direction,
a surface H2 of the hologram portion is adjacent to one surface B'1 of a second lens blank with two surfaces,
the other surface B'2 of the second lens blank has a concave and spherical shape, and
the surface B1 of the first lens blank is formed into a convex or flat shape in the step of producing."

In the second embodiment, the surface B1 of the first lens blank is processed in accordance with the prescription to form the object-side surface S1 of the spectacle lens. To reiterate, in one embodiment of the present invention, the plate-like hologram portion is taken as a premise. In addition, in the second embodiment, the second lens blank is taken as a premise. Accordingly, in the second embodiment, the surface B'2 of the second lens blank serves as the eye-side surface S2 of the spectacle lens. Accordingly, by taking the form of the hologram portion into consideration in advance and processing the surface B1 of the first lens blank in accordance with the prescription to be satisfied, it is sufficient to produce the spectacle lens that satisfies the prescription.

### <Spectacle Lens and Spectacles>

One specific example of the configuration of the spectacle lens in the second embodiment is as follows.

"A spectacle lens that satisfies a wearer's prescription, the spectacle lens irradiating a hologram layer within the spectacle lens with laser light reflected by a MEMS (micro-electromechanical systems) mirror to allow a wearer of the spectacle lens to visually recognize a virtual image, the spectacle lens including:
a first lens; and
a second lens; and
a plate-like hologram portion that includes the hologram layer, wherein
the hologram portion has a cylindrical shape that curves in a horizontal direction,
one surface L2 of the first lens with two surfaces is adjacent to one surface H1 of the hologram portion,
a surface H2 of the hologram portion is adjacent to one main surface L'1 of the second lens with two surfaces,
the other surface L'2 of the second lens has a concave and spherical shape,
a surface L1 of the first lens has a convex or flat shape,
an object-side surface S1 of the spectacle lens is the surface L1 of the first lens, and
an eye-side surface S2 of the spectacle lens is the surface L'2 of the second lens."

One specific example of the configuration of the spectacles in the second embodiment is as follows.

"Spectacles including: the spectacle lens described above; and
a spectacle frame."

In the second embodiment, the spectacle lens and the spectacles are resultants in which the eye-side surface F2 of the semi-finished lens is fixed. In the first embodiment, the refractive power at the eye-side surface S2 of the spectacle lens, which corresponds to one of a plurality of spots described in PTL 2, such as the interface between the reflective hologram and the lens substrate, and the interface between the lens substrate and the outside world, does not change depending on the prescription of the wearer. This is because, in the second embodiment, which is of a simple fixed-lens type, the eye-side surface S2 of the spectacle lens is formed by the surface B'2 of the second lens blank, which is taken as a premise.

As a result, the spectacle lens and the spectacles in the second embodiment allow the wearer to visually recognize a clear virtual image, thereby solving the problem (2).

The embodiments of the present invention have been described above. However, the foregoing disclosure merely illustrates the exemplary embodiments of the present invention. That is, the technical scope of the present invention is not limited to the foregoing exemplary embodiments and may be modified in various ways without departing from the gist of the present invention. Furthermore, the foregoing disclosure may be arbitrarily selected and combined with the following modified examples.

The technical concept of the present invention is also reflected in virtual image display systems including the above spectacle lens and an image light emission unit, i.e., a MEMS, that emits image light, as well as in a program for causing a computer to exhibit the functions implemented by the systems.

### [Reference Signs List]

- 1: Spectacle lens
- S1: Object-side surface of spectacle lens
- S2: Eye-side surface of spectacle lens
- 2: Hologram portion
- 21: Hologram layer
- 21A: Exposed portion
- 21B: Non-exposed portion
- 22: Base portion
- H1: Object-side surface of hologram portion
- H2: Eye-side surface of hologram portion
- 3: First lens
- L1: Object-side surface of first lens
- L2: Eye-side surface of first lens
- 40: Second lens (in reference example)
- M: MEMS
- E: Eye
- V: Light flux of virtual image (from image light emission unit)
- R: Light flux of real image (from outside world)
- O: Pupil center and lens center
- I: Image of virtual image

## Claims

1. A method for producing a spectacle lens that satisfies a wearer's prescription, the spectacle lens irradiating a hologram layer within the spectacle lens with laser light reflected by a MEMS (micro-electromechanical systems) mirror to allow a wearer of the spectacle lens to visually recognize a virtual image, the method comprising:
a step of producing the spectacle lens by processing, in a semi-finished lens in which one surface H1 of a plate-like hologram portion including the hologram layer is adjacent to one surface B2 of a first lens blank with two surfaces, the other surface B1 of the first lens blank in accordance with the prescription to form an object-side surface S1 of the spectacle lens, thereby obtaining the spectacle lens that satisfies the prescription.

2. The method for producing the spectacle lens according to claim 1, wherein an eye-side surface S2 of the spectacle lens is the other surface H2 of the hologram portion.

3. The method for producing the spectacle lens according to claim 1, wherein the hologram portion has a shape that follows the hologram layer.

4. The method for producing the spectacle lens according to claim 1, wherein the hologram portion is composed of the hologram layer joined to a layered base portion.

5. The method for producing the spectacle lens according to claim 1, wherein a distance d2 in a lens thickness direction from an eye-side surface S2 of the spectacle lens to the hologram layer is set to be smaller than a distance d1 in the lens thickness direction from the object-side surface S1 of the spectacle lens to the hologram layer.

6. The method for producing the spectacle lens according to claim 5, wherein a value of the d2/the d1 is 0.2 or less.

7. The method for producing the spectacle lens according to claim 1, wherein the hologram portion has a cylindrical shape that curves in a horizontal direction,
a surface H2 of the hologram portion is adjacent to one surface B'1 of a second lens blank with two surfaces,
the other surface B'2 of the second lens blank has a concave and spherical shape, and
the surface B1 of the first lens blank is formed into a convex or flat shape in the step of producing.

8. A semi-finished lens for producing a spectacle lens that satisfies a wearer's prescription, the spectacle lens irradiating a hologram layer within the spectacle lens with laser light reflected by a MEMS (micro-electromechanical systems) mirror to allow a wearer of the spectacle lens to visually recognize a virtual image, the semi-finished lens comprising:
a first lens blank; and
a plate-like hologram portion that includes the hologram layer, wherein
one surface B2 of the first lens blank with two surfaces is adjacent to one surface H1 of the hologram portion,
one surface F1 of the semi-finished lens with two surfaces is the other surface B1 of the first lens blank, and
the other surface F2 of the semi-finished lens is the other surface H2 of the hologram portion.

9. A semi-finished lens for producing a spectacle lens that satisfies a wearer's prescription, the spectacle lens irradiating a hologram layer within the spectacle lens with laser light reflected by a MEMS (micro-electromechanical systems) mirror to allow a wearer of the spectacle lens to visually recognize a virtual image, the semi-finished lens comprising:
a first lens blank; and
a second lens blank; and
a plate-like hologram portion that includes the hologram layer, wherein
the hologram portion has a cylindrical shape that curves in a horizontal direction,
one surface B2 of the first lens blank with two surfaces is adjacent to one surface H1 of the hologram portion,
a surface H2 of the hologram portion is adjacent to one surface B'1 of the second lens blank with two surfaces,
the other surface B'2 of the second lens blank has a concave and spherical shape, and
one surface F1 of the semi-finished lens with two surfaces is the other surface B1 of the first lens blank, and
the other surface F2 of the semi-finished lens is the surface B'2 of the second lens blank.

10. The semi-finished lens according to claim 8 or 9, wherein the hologram portion has a shape that follows the hologram layer.

11. The semi-finished lens according to claim 8 or 9, wherein the hologram portion is composed of the hologram layer joined to a layered base portion.

12. The semi-finished lens according to claim 8 or 9, wherein a distance t2 in a lens thickness direction from the surface F2 of the semi-finished lens to the hologram layer is set to be smaller than a distance t1 in the lens thickness direction from the surface F1 of the semi-finished lens to the hologram layer.

13. The semi-finished lens according to claim 12, wherein a value of the t2/the t1 is 0.2 or less.

14. A spectacle lens that satisfies a wearer's prescription, the spectacle lens irradiating a hologram layer within the spectacle lens with laser light reflected by a MEMS (micro-electromechanical systems) mirror to allow a wearer of the spectacle lens to visually recognize a virtual image, the spectacle lens comprising:
a first lens; and
a plate-like hologram portion that includes the hologram layer, wherein
one surface L2 of the first lens with two surfaces is adjacent to one surface H1 of the hologram portion,
an object-side surface S1 of the spectacle lens is the other surface L1 of the first lens, and
an eye-side surface S2 of the spectacle lens is the other surface H2 of the hologram portion.

15. A spectacle lens that satisfies a wearer's prescription, the spectacle lens irradiating a hologram layer within the spectacle lens with laser light reflected by a MEMS (micro-electromechanical systems) mirror to allow a wearer of the spectacle lens to visually recognize a virtual image, the spectacle lens comprising:
a first lens; and
a second lens; and
a plate-like hologram portion that includes the hologram layer, wherein
the hologram portion has a cylindrical shape that curves in a horizontal direction,
one surface L2 of the first lens with two surfaces is adjacent to one surface H1 of the hologram portion,
a surface H2 of the hologram portion is adjacent to one main surface L'1 of the second lens with two surfaces,
the other surface L'2 of the second lens has a concave and spherical shape,
a surface L1 of the first lens has a convex or flat shape,
an object-side surface S1 of the spectacle lens is the surface L1 of the first lens, and
an eye-side surface S2 of the spectacle lens is the surface L'2 of the second lens.

16. The spectacle lens according to claim 14 or 15, wherein the hologram portion has a shape that follows the hologram layer.

17. The spectacle lens according to claim 14 or 15, wherein the hologram portion is composed of the hologram layer joined to a layered base portion.

18. The spectacle lens according to claim 14 or 15, wherein a distance d2 in a lens thickness direction from the eye-side surface S2 of the spectacle lens to the hologram layer is smaller than a distance d1 in the lens thickness direction from the object-side surface S1 of the spectacle lens to the hologram layer.

19. The spectacle lens according to claim 18, wherein a value of the d2/the d1 is 0.2 or less.

20. Spectacles comprising: the spectacle lens according to claim 14 or 15; and
a spectacle frame.
